# EUROPEAN PATENT SPECIFICATION

(11) **EP 2 168 149 B1**
(45) Date of publication and mention of the grant of the patent: **19.06.2013**
(21) Application number: 08743480.9
(22) Date of filing: 15.02.2008
(51) Int. Cl.: H01L 21/322, H01L 31/18

(54) **A METHOD FOR REMOVING IMPURITIES FROM LOW-GRADE CRYSTALLINE SILICON WAFERS**
VERFAHREN ZUR ENTFERNUNG VON UNREINHEITEN BEI GERINGWERTIGEN KRISTALLINEN SILICIUMWAFERN
PROCEDE D'ENLEVEMENT DES IMPURETES DES PLAQUETTES EN SILICIUM MONOCRISTALLIN DE QUALITE INFERIEURE

(30) Priority: 16.02.2007 US 676095
(43) Date of publication of application: 31.03.2010
(73) Proprietor: Silicor Materials Inc., Palo Alto, CA 94301 (US)
(72) Inventor: RAKOTONIAINA, Jean, Patrice, D-12456 Berlin (DE); HEUER, Matthias, 04275 Leipzig (DE); KIRSCHT, Fritz, D-12621 Berlin (DE); LINKE, Dieter, 12527 Berlin (DE); OUNADJELA, Kamel, Belmont, CA 94002 (US)
(74) Representative: Danner, Stefan
(86) International application number: PCT/US2008/054052
(87) International publication number: WO 2008/101144

(56) References cited:
- US-A- 4 383 268
- US-A- 4 416 051
- US-A- 4 878 988
- US-A- 5 871 591
- US-A1- 2006 263 957
- US-A1- 2006 289 091
- MARTINUZZI S ET AL: "TOWARD LOW COST POLYCRYSTALLINE SILICON WAFERS FOR HIGH EFFICIENCY SOLAR CELLS", APPLIED SOLAR ENERGY (GELIOTEKHNIKA), ALLERTON PRESS INC, NEW YORK, US, vol. 28, no. 6, 1 January 1992 (1992-01-01), pages 38-45, XP000367063, ISSN: 0003-701X
- KIM ET AL.: 'Characteristics of structural defects in the 240 kg silicon ingot grown by directional solidification process' SOLAR ENERGY MATERIALS AND SOLAR CELLS vol. 90, no. 11, 05 December 2005, pages 1666 - 1672, XP005393271
- SAITOH ET AL.: 'Impurity gettering of polycrystalline solar cells fabricated from refined metullurgical-grade silicon' IEEE TRANSACTIONS ON ELECTRON DEVICES vol. 27, no. 4, April 1980, pages 671 - 677, XP000836670

## Description

### FIELD

The present invention relates to devices formed from a semiconductor substrate, such as a crystalline silicon substrate, and, more particularly to a method for removing impurities from low-grade crystalline silicon wafers, including by gettering impurities using phosphorus diffusion on damaged surfaces of such substrates.

### DESCRIPTION OF THE RELATED ART

Materials alternatives for solar cells range from single-crystal, electronic-grade (EG) silicon to relatively dirty, metallurgical-grade (MG) silicon. EG silicon yields solar cells having efficiencies close to the theoretical limit of all silicon materials, but at a prohibitive price. On the other hand, the less expensive MG silicon typically fails to produce working solar cells. There may be other semiconductor materials that are useful for solar cell fabrication. In practice, however, nearly 90% of commercial solar cells are made of crystalline silicon.

Several factors determine the quality of silicon materials that may be useful for solar cell fabrication. These factors may include, for example, transition metal and/or other dopant content and their distribution throughout the silicon substrate. Transition metals pose a principal challenge to the efficiency of crystalline silicon solar cells. Multicrystalline silicon solar cells may tolerate transition metals such as iron (Fe), copper (Cu), or nickel (Ni) in concentrations up to 10¹⁶ cm⁻³, because metals in multicrystalline silicon are often found in less electrically active inclusions or precipitates, often located at structural defects (e.g., grain boundaries), rather than being atomically dissolved. However, no simple correlation exists between the total metal content of the semiconductor wafer and cell efficiencies across different. Accordingly, understanding the physics and the properties of metal clusters in solar cells, as well as using these properties to operational and economic advantage, could yield significant process and product improvements. Such improvements, because of their associated enhanced economies and manufacturability, are likely to make solar power attractive and practical for an essentially unlimited number of energy demands.

The purity requirements for the semiconductor materials that may be useful in solar cells typically are not as stringent as are those for the integrated circuitry industry. In fact, the solar cell industry may sometimes use recycled, scrapped, or rejected semiconductor material from the integrated circuitry industry. However, transition metal impurities are known to decrease the solar cell conversion efficiency. This leads to poor performance and a poor cost-to-performance ratio. While the impurities may be removed using a variety of well-known techniques for purifying silicon, known techniques add additional cost to the solar cell manufacturing process. This, in essence, vitiates the motivation for using such lower quality Refined Metallurgical silicon RMG wafers.

In attempting to use a lower-grade silicon for solar cell and similar applications, approaches employing phosphorus gettering have been proposed. One particular approach seeks to perform phosphorus gettering during the fabrication of a solar cell emitter. A modification to this approach changes the temperature profile of the phosphorus diffusion by adding a low temperature tail in the process. This further modification may result in carrier lifetime enhancements beyond those of more traditional phosphorus gettering techniques.

A known phosphorus gettering process for a silicon wafer seeks to enhance carrier lifetime during phosphor indiffusion when forming the p-n junction. Unfortunately, this known phosphorus gettering technique has generated mixed results. For example, in one instance an increase of carrier lifetime of as much as three times has been observed on regions having low dislocation densities. On the other hand, in regions of high dislocation densities, no measurable carrier lifetime increase occurred.

Furthermore, U.S. Patent No. 4,878,988 relates to a method including sawing an ingot to create a semiconductor wafer with damaged surfaces, subjecting the wafer to high temperatures to getter the impurities to the damaged surfaces, and lapping the wafer to remove the damaged regions and the gettered impurities.

The publication of Martinuzzi and coworkers (Martinuzzi, S. et al. (1992) "Toward Low Cost Polycrystalline Silicon Wafers for High Efficiency Solar Cells," Applied Solar Energy, vol. 28, pages 38-45) relates to phosphorous gettering in silicon wafers.

While other approaches have been made, no approach provides the benefits of occurring prior to solar cell fabrication or without requiring a complicated lapping process for semiconductor wafer preparation.

Accordingly, there is the need for a process, including a phosphorus gettering process that not only getters impurities, but also removes impurities from the semiconductor wafer and that prior to cell fabrication.

There is the need for a process that removes impurities from semiconductor wafers, while at the same time providing for the formation of gettering sites to enhance the diffusion of impurities from the substrate. Yet, this need must be met without further expense and process complexity.

Yet a further need exists for a process for impurity gettering in a semiconductor substrate wherein the gettering sites at a desired location of the wafer may be formed before gettering occurs. Such a process would most advantageously provide for the surface of the substrate to be prepared for a gettering process, and then exposed to phosphorus gettering.

Meeting the above-stated needs could provide a significant improvement in the formation of silicon wafers from lower-grade silicon, thereby aiding to make solar power generation systems using such solar cells much more economical and achievable.

### SUMMARY

Techniques are here disclosed for providing improved semiconductor solar cells using low grade semiconductor material. The presently disclosed process removes impurities in a semiconductor substrate such as a refined metallurgical-grade crystalline silicon substrate or device. This process is defined by the technical features as specified in independent claim 1, including forming lattice damage on at least one, and preferably two, sides of the semiconductor substrate , wherein lattice damage is induced mechanically. Thereafter, phosphorus gettering the substrate at a sufficient temperature and time causes impurities to diffuse close to the gettering centers of the substrate surface. Optionally, a subsequent hydrogen treatment may passivate defects in the silicon substrate. A subsequent etch step then removes the damaged regions along with the gettered impurities. Principally, the present disclosure relates to silicon materials, although use of other semiconductor materials may be within the scope of the presently claimed method and system.

According to another aspect of the disclosed subject matter, therefore, a solar cell pre-processing method is provided for removing impurities from low-grade crystalline silicon wafers. The disclosed pre-processing method removes impurities from low-grade crystalline semiconductor wafers having high impurity content. The process damages at least one surface of the semiconductor wafer, either in the semiconductor wafer forming step or in a separate step, to form a region on the surface that includes a plurality of gettering centers. The gettering centers attract impurities from the substrate during subsequent processing. The subsequent processes include diffusing impurities from the substrate using a phosphorus gettering process that includes impregnating the wafer surface with a phosphorus material that facilitates the formation of impurity clusters associated with the gettering centers. Then, the process removes from the at least one surface a portion comprising the impregnated phosphorus material and the impurity clusters to yield a semiconductor wafer comprising a substrate having a generally reduced impurity content. The low-grade semiconductor wafer may be, for example, refined metallurgical grade crystalline silicon or upgraded metallurgical grade crystalline silicon material.

These and other advantages of the disclosed subject matter, as well as additional novel features, will be apparent from the description provided herein as well as from the independent claims. The intent of this summary is not to be a comprehensive description of the claimed subject matter, but rather to provide a short overview of some of the subject matter's functionality. Other methods, features and advantages here provided will become apparent to one with skill in the art upon examination of the following FIGUREs and detailed description. It is intended that such additional methods, features and advantages be included within this description, be within the scope of the accompanying claims.

### BRIEF DESCRIPTIONS OF THE DRAWINGS

The features, nature, and advantages of the disclosed subj ect matter may become more apparent from the detailed description set forth below when taken in conjunction with the drawings in which like reference characters identify correspondingly throughout and wherein:

**FIGURE 1** depicts a known process for forming a semiconductor solar cell;

**FIGURE 2** illustrates generally an aspect of the disclosed subject matter for forming a semiconductor solar cell;

**FIGURE 3** conceptually presents an EG semiconductor substrate for comparing to a semiconductor substrate modified according to the present teachings;

**FIGUREs 4** and **5** conceptually show a semiconductor wafer experiencing the benefits of the disclosed process;

**FIGURE 6** shows schematically the wafer with impurities and the damages on both surfaces of the wafers;

**FIGURE 7** illustrates the effect of gettering after phosphorus diffusion; and

**FIGURE 8** shows the wafer after removal of damage and impurities; and

**FIGURE 9** shows a time versus temperature profile for an aspect of the disclosed subject matter.

### DETAILED DESCRIPTION OF THE SPECIFIC EMBODIMENTS

The method of the present disclosure permits removing impurities from low-grade crystalline silicon wafers for concentrating impurities and related complexes, in particular, transition metal clusters, existing throughout a semiconductor substrate. As a result of using the presently disclosed subject matter, an improvement in the properties of low-grade semiconductor materials, such as RMG or UMG silicon, occurs. Such improvement allows use of refined MG (RMG) silicon, for example, in producing solar cells as may be used in solar power generation and related uses.

The method of the present disclosure, moreover, particularly benefits the formation of semiconductor solar cells using RMG silicon or other non-electronic grade semiconductor materials. The present disclosure may find application in the economical manufacture of solar cells, allowing the formation of solar cells in greater quantities and in a greater number of fabrication facilities than has heretofore been possible.

The present invention is a process for removing impurities in a semiconductor substrate such as a silicon substrate. The process comprises first creating a mechanically damaged region preferably on both sides of a low-grade silicon wafer. This may be done by sawing the ingot into numerous wafers. Here the parameter of ingot sawing (e.g. slurry size) may be changed in order to create optimal damage. Thereafter, the wafer is submitted to phosphorus diffusion for a sufficient temperature and time period to assure effective phosphorus gettering. After the gettering process follows the removal of the impurities in the damaged surfaces.

Among various technical advantages and achievements herein described, certain ones of particular note include the ability to reduce the amount of impurities present in a semiconductor wafer such as a silicon wafer in a process occurring prior to the standard solar cell fabrication. The disclosed subject matter enables processes for inexpensively making wafer treatments needed for highly efficient mass scale solar cell production. Still further, the present disclosure makes possible advantageous use of saw damage that may be inherently present after slicing a silicon ingot into wafers. That is the inherent saw damage that occurs in slicing a semiconductor wafer benefits attracting impurities in favorable thermodynamic process conditions. Also, by adding one or more contaminated layers with controlled levels of foreign atoms (such as other gattering agents) at the wafer surface, the disclosed process supports gettering impurities during a favorable thermodynamic treatment. The foreign atoms may include metals (e.g., iron, nickel and copper) and non-metals (e.g., phosphorus, oxygen). The process of the present disclosure removes a highly contaminated layer at the surface of the wafer using etching prior to the solar cell fabrication. The process, thereby, reduces the concentration of electrically active species within grains, while concentrating metallic impurities at grain boundaries in multicrystalline silicon. Such active species may include dislocations and metallic impurities. The disclosed subject matter, therefore, generates denuded zones in silicon wafers by applying treatments that reduce the concentration of non-surface electrically active species. Such non-surface electrically active species may be, for example, intra-grain dislocations and metallic impurities.

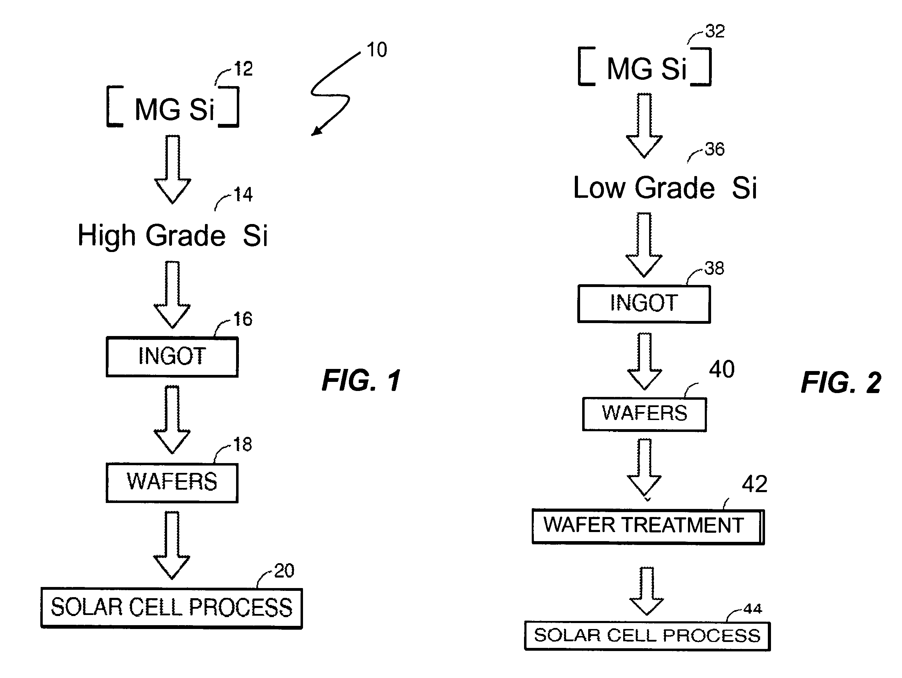

Laying a context for the present disclosure, **FIGURE 1** depicts a known process **10** beginning at step **12**. At step **12**, MG or other low-grade silicon enters known wafer forming process flow **10**. Known process flow **10** extracts high-grade silicon from MG silicon at step **14**. High-grade silicon extraction step **14** is a high-cost processing sequence resulting in EG silicon or somewhat relaxed silicon quality called Solar-grade (SoG) silicon quality. Those are the types of silicon feedstock materials used for making the ingot in step **16**. Known process flow **10** includes slicing the silicon ingot, generally using a wire-saw to derive a silicon wafer at step **18**. The resulting silicon wafers then enter solar cell formation process **20** using the resulting wafer.

**FIGURE 2** depicts, in general terms, novel aspects of how the disclosed semiconductor wafer phosphorus gettering process may occur during the overall solar cell fabrication flow **30**. Fabrication flow **30** includes using MG silicon at steps **32** that may be purified to some degree to become UMG or RMG silicon. The resulting silicon quality still results in low-grade silicon **36**. Accordingly, silicon quality **36** relates to much lower cost as compared to silicon quality **14**. Also, silicon quality **36** means much higher content of metallic and non metallic impurities as compared to silicon quality **14**. Thereafter, at step **38**, silicon ingot formation may occur. Step **40** represents the formation of silicon wafers, i.e., slicing from the silicon ingot. Then, the novel aspect of the disclosed solar cell forming process flow is introducing a wafer treatment step **42,** also called pre-process step, before starting the cell process. This wafer treatment step **42** is starting by surface cleaning to remove residual impurities on the wafers surfaces and the native oxide layer. This cleaning step does not affect the surface damages. Finally, the solar cell forming process occurs at step **44**.

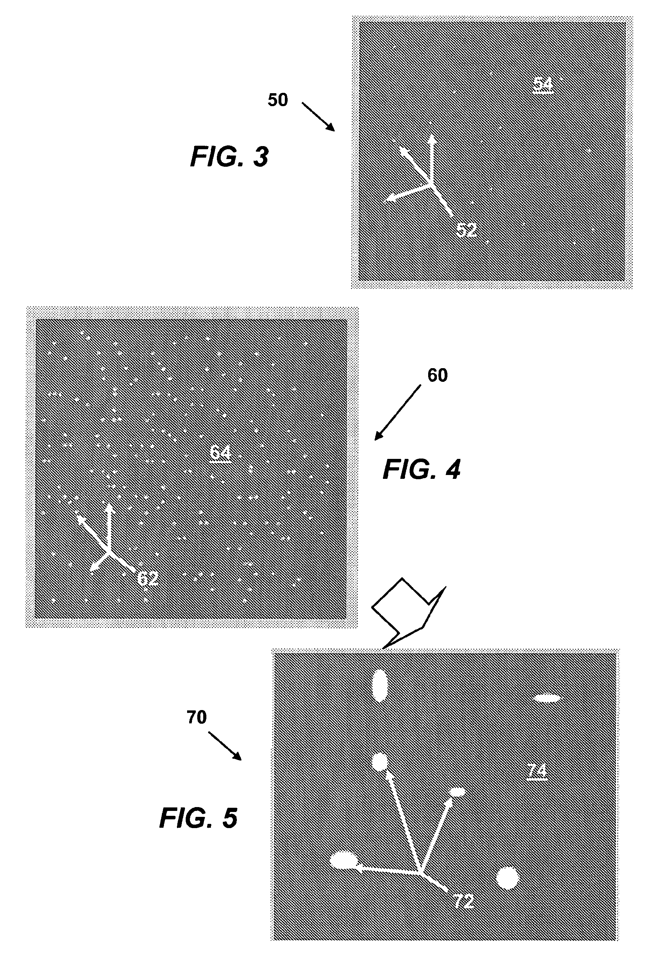

**FIGURE 3** further establishes the context of the disclosed subject matter by depicting conceptually a high quality, EG silicon wafer **50**. Silicon wafer **50**. includes pure silicon substrate **52** which, even in the most pure form, contains at least trace impurities and some level of structural defects **54**. Generally, such impurities and defects only affect solar cell performance slightly. However, there is always some performance cost for these impurities and defects. The performance costs of potential or actual solar cell operation limitation must, however, weigh against the time, effort, and process expense costs of their removal. In known EG silicon wafers used for solar cells, a balance between costs of using EG silicon, on the one hand, and performance, on the other hand, exists. The result becomes solar cells with good performance for most demands, yet with unacceptable manufacturing costs.

In contrast, **FIGUREs 4** shows a lower quality, lower cost, and more abundant silicon wafer **60** having metallic and other impurities and a variety of lattice defects **62**. Impurities and defects **62** are somewhat uniformly distributed throughout silicon substrate **64**. **FIGURE 5** shows that the disclosed process employs novel applications of annealing and gettering to transform silicon wafer **60** into silicon wafer **70** having clusters of metallic impurities **72**. That is, through the presently disclosed process and system, a significant amount of impurities **62** migrate to form impurity clusters **72** at desired locations, such as near-surface layers or grain boundaries of silicon wafers **74**.

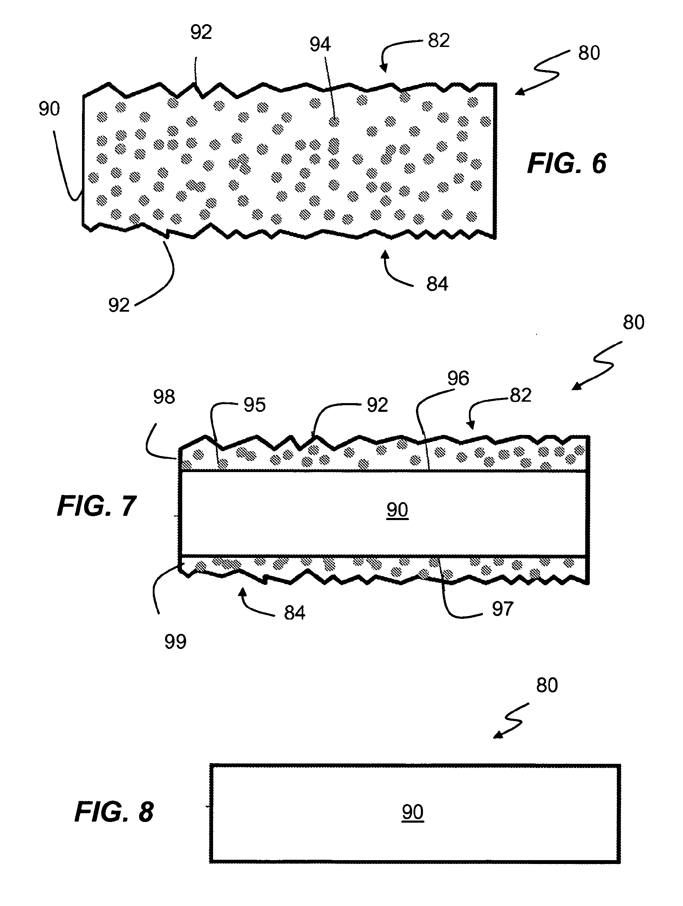

The present disclosure includes significant use of phosphorus gettering manipulation of a "denuded zone" to achieve silicon wafers having properties similar to silicon wafer **70** of **FIGURE 5**. The use of a "denuded zone" possessing saw or other lattice structure damage at the surface of silicon wafer, as well as phosphorus gettering that enable and facilitate the migration and clustering of transition metals, as described below in **FIGUREs 6** through **8**, to provide a wafer pre-process that economically transforms heretofore unusable or marginally usable low-grade UMG, and/or RMG silicon into a modified silicon wafer **70**. Moreover, due to the non-obvious and elegant simplicity of the combined processes, such modifications yield silicon wafers exhibiting the properties of silicon wafer **70** with minimal additional process complexities or overall fabrication costs.

The present disclosure establishes thermal conditions for dissolving metals from grown-in clusters or precipitates and moving relatively fast diffusing and some portion of relatively slow diffusing metals into gettering centers at or near the damaged surface region of the semiconductor wafer. After the disclosed phosphorus gettering process occurs, the near-surface layer having impurity clusters at or near the gettering centers, as well as the phosphorus impregnated portions of the semiconductor wafer surface may be etched off, as herein described.

**FIGUREs 6** through **8** illustrate process steps for a phosphorus gettering sequence of steps for semiconductor wafer **80**. Semiconductor wafer **80** of **FIGURE 6** includes top surface **82** and bottom surface **84**. As shown in **FIGURE 6**, all top surface **82** and bottom surface **84** show wire-sawn damage surfaces. Semiconductor substrate **90** appears in semiconductor wafer **80** of **FIGURE 6**. Semiconductor wafer **80** is obtained by slicing a silicon ingot. One such silicon ingot appears in U.S. Patent Application Serial No. 11/700,391, entitled "METHOD AND SYSTEM FOR FORMING A HIGHER PURITY SEMICONDUCTOR INGOT USING LOW PURITY SEMICONDUCTOR FEEDSTOCK" filed on January 31, 2007

Mechanical damage **92** may be created on both top surface **82** and bottom surface **94** of silicon wafer **80**. Photovoltaic starting materials, e.g., crystalline or multicrystalline silicon ingots, oftentimes have higher impurities than do most EG ingots. Therefore, semiconductor wafer **80**, when cut from such silicon ingots have also high bulk defects and impurities **94** content which are distributed in the wafer. Semiconductor substrate **90** may further include dispersed lattice defects, small clusters of metallic impurities, grain boundaries, and medium-size clusters of metallic impurities. The present description of aspects of one side of semiconductor wafer **80** may apply to either or both sides. Such grain boundaries may separate lattice orientations and, thereby, individual grains within semiconductor substrate **90.**

**FIGURE 6**, therefore, depicts the initial state of wire-sawn semiconductor wafer **80**. The commonly used technique for slicing a semiconductor ingot into wafers uses a wire-saw. The wire-saw includes a series of mandrels about which a very long wire is looped and then driven through the ingot as a silicon carbide or boron carbide slurry is dripped onto the wire. The wire-sawing technique, for example, may slice a semiconductor ingot using a length of diamond impregnated wire in which the ingot is rotated about its longitudinal axis as the diamond wire is driven back and forth orthogonal to the ingot's longitudinal axis. There may be other ways to use the wire-saw for slicing the semiconductor wafer.

**FIGURE 7** illustrates semiconductor wafer **80** after a sequence of phosphorus diffusion steps for gettering impurities **92**. In a preferred embodiment, phosphorus gettering occurs in a process achieving a sheet resistance in the range of **10** to **40** Ω**/Sq**, a temperature range **of 900 °C**, and a duration of approximately one hour. Other process parameters (sheet resistance, temperature, time) may optimize the gettering process for various different types of semiconductor materials and types of impurities. Lines **96** and **97** conceptually demark regions **98** and **99** for illustrating gettered layers near top surface **82** and bottom surface **84**, respectively, that derive from the presently disclosed process.

Assuming phosphorus to be distributed uniformly in regions **98** and **99**, concentrations may reach approximately 1x10²⁰ atoms/cm³. In this manner, top surface **82** and bottom surface **84** may become a phosphorus impregnated or implanted regions.

The present disclosure takes advantage of the wire-saw damaged surfaces **82** and **84** of semiconductor wafer **80**. That is, the wire-saw damage has the characteristics of attracting metallic impurities by lattice damage and related defects generated mechanically and thermally. This means, those structural defects serve as external gettering centers for metallic impurities during thermal treatment and post-anneal cooling as indicated in **FIGURE 7****.**

Generally dispersed, relatively small impurity clusters **94** will partially or almost completely dissolve under proper thermodynamic conditions, and the freed metallic impurities will migrate from a general dispersion within semiconductor substrate **90** to a concentrated state in regions **98** and **99**. As such, there may be other ways beyond the wire saw to mechanically cause the now desirable surface conditions. Alternatively, there may be ways of modifying the conventional wire saws and/or sawing processes as may be used in cutting a semiconductor wafer **80** from a semiconductor ingot. Still further, the present disclosure contemplates the use of various measurements and control means for determining, controlling and varying the amount of wire saw damage that semiconductor wafer **80** may experience. Such modifications may be designed to enhance the defect gettering effects of the wire-saw damage and are clearly within the scope of the presently claimed subject matter.

Regardless of the wire-saw process employed, at some level, the wafer formation process causes damage which is transformed into suitable lattice defects used for external gettering of metallic impurities. **FIGURE 8** presents the semiconductor wafer **80** following etching and cleaning the respective semiconductor wafer **80**. In this stage, semiconductor wafer **80** has a near-surface layer denuded of electronically active species and an etch-process controlled, relatively smooth surface. Metal clustering at annealing may also occur in near-surface regions **98** and **99** also in concentrated form at multicrystalline silicon grain boundaries in substrate **90**.

**FIGURE 8** shows semiconductor wafer **80** after etching the phosphorus gettered layer. At this point, semiconductor wafer **80** should possess reduced impurity content and may be used for further processing in solar cell fabrication to yet a highly satisfactorily functioning solar cell.

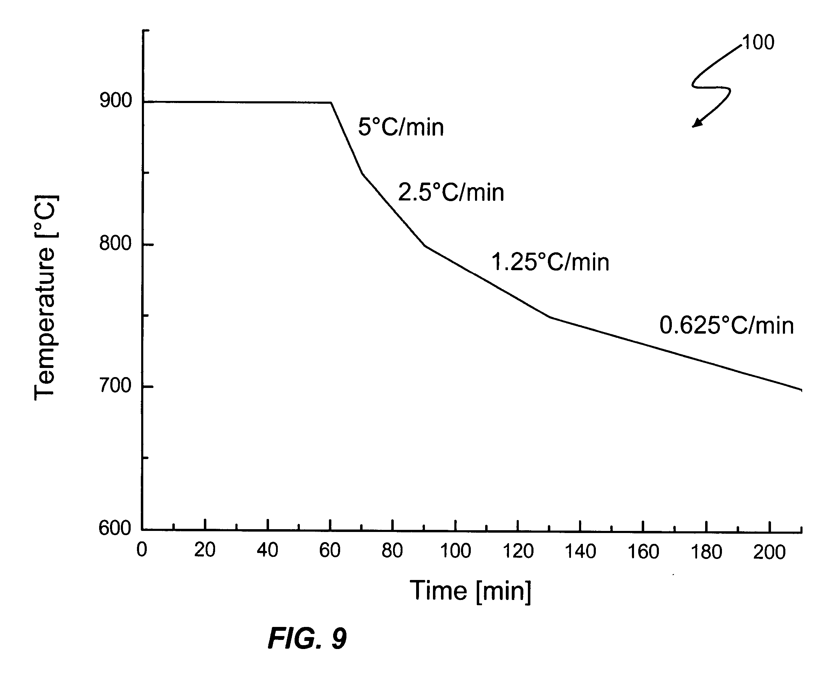

Figure 9 shows an example of a temperature profile for the gettering step. This profile is a so-called "graded ramp-down". The profile can be divided in two parts, a conventional gettering step 100 and a ramp down using successively lower cooling rates 102. The main idea is to increase the external gettering efficiency of this processing step. The graded cooling regime is applied for two reasons: On one hand a slowly increasing supersaturation of metallic impurities to be gettered has to be realized since supersaturation is the driving force for metals to re-distribute to the desired gettering sinks. On the other hand successively more time is needed to allow those impurities to reach the near-surface getter regions at lower temperatures. This balanced approach leads to higher gettering efficiency per total time applied for the external gettering process.

Thus, as **FIGURE 8** depicts, semiconductor substrate **90** now has a significantly lower concentration of impurities **92** in comparison to the distribution of impurities appearing in **FIGURE 6**. The disclosed subject matter, therefore, provides a method for removing impurities from low-grade crystalline silicon wafers solar cell pre-processing methods for phosphorus gettering a solar cell semiconductor wafer having impurities such as transition metals and a variety of structural defects. The method provide, respectively, the steps of and means for reducing the impurity levels in semiconductor wafers by utilizing mechanical lattice damage and related structural defects in near-surface regions of such wafers. Such lattice damage may arise from saw damaged near-surface layers of a semiconductor wafer occurring inherently from slicing blocks into wafers.

As a result of the gettering and clustering of impurities toward top surface **82** and bottom surface **84**, the impurities transition from being generally dispersed in a semiconductor wafer to becoming concentrated close to the surfaces of respective wafers. A cooling step follows the annealing step for forming and retaining the metal-containing clusters within the surface regions. This increases the purity level of the semiconductor wafer in regions from which the impurities are gettered. The disclosed method and system remove the largely contaminated wafer surface layer, including the impurity clusters, to yield a semiconductor wafer having a generally higher purity level. Removed thickness may vary between 1µm -40µm using standard etching procedures for removal.

The disclosed subject matter, therefore, includes adding purposely at least one contaminated surface layer, containing metallic impurities with a concentration ranging from 10¹⁰-10¹⁷ cm⁻³, on top of the saw damaged surfaces of the wafer. This layer adds defined amounts of metallic species which will favor the formation of large inter-metallic clusters during the annealing treatment. Large impurity clusters form partially in the near-surface regions and thereby getter impurities, so that the procedure is similar to the one described above which involves annealing at sufficiently high temperature, cooling at a thermodynamically favorable rate and then removing the layer using standard etching techniques.

Although various embodiments which incorporate the teachings of the present disclosure have been shown and described in detail herein, those skilled in the art may readily devise many other varied embodiments that still incorporate these teachings. For example, many different types of phosphorus gettering steps, etch and cleaning steps and other processing steps may be performed in association with the disclosed process Also the present embodiments may be implemented in a batch or single wafer processes or in repeated sequences of annealing and processing steps as herein detailed, all such modifications falling within the scope of the present disclosure. The foregoing description of the preferred embodiments, therefore, is provided to enable any person skilled in the art to make or use the claimed subject matter. Various modifications to these embodiments will be readily apparent to those skilled in the art, and the generic principles defined herein may be applied to other embodiments without the use of the innovative faculty. Thus, the scope of the invention is defined by the terms of the claims.

## Claims

1. A method for removing impurities from low-grade crystalline semiconductor wafers, comprising the steps of:
forming a low-grade semiconductor wafer comprising a substrate having a high impurity content;
mechanically damaging at least one surface of said semiconductor wafer, either in said forming step or in a separate step, thereby forming lattice damage on the at least one surface, for forming a region on said at least one surface comprising a plurality of gettering centers;
diffusing impurities from said substrate using a phosphorus gettering process, said phosphorus gettering process comprising the step of impregnating said at least one surface with a phosphorus material and adding one or more contaminated layers with controlled levels of other gettering agents on the at least one surface, said other gettering agents being selected from iron, nickel, and copper and having a concentration ranging from 10¹⁰-10¹⁷ cm⁻³, to form impurity clusters associated with said gettering centers, said impurity clusters comprising the impurities that diffused; and
removing from said at least one surface a portion comprising said impregnated phosphorus material, said impurity clusters, and said one or more contaminated layers from said at least one surface to yield a semiconductor wafer comprising a substrate having a generally reduced impurity content.

2. The method of claim 1, wherein said at least one surface comprises both surfaces of a semiconductor wafer.

3. The method of claim 1, wherein said semiconductor wafer comprises an upgraded metallurgical silicon wafer.

4. The method of claim 1, wherein said step of damaging said at least one surface of said semiconductor wafer further comprises the step of damaging said at least one surface using a wire saw in slicing said semiconductor wafer from a semiconductor ingot.

5. The method of claim 1, wherein said phosphorus gettering process further comprises heating to a temperature of 900°C and for a duration of one hour, thereby resulting in a sheet resistance of the semiconductor wafer of 10 to 40 Ω/square.

6. The method of claim 1, wherein said removing step further comprises the step of removing from said at least one surface a portion comprising said impregnated phosphorus material and said impurity clusters using a step of chemically etching said portion comprising said impregnated phosphorus material and said impurity clusters.

7. The method of claim 1, wherein said impurities comprise elements from the group consisting essentially of transition metals, metallic impurities, non-metallic impurities, and mixed or pure clusters of said transition metals, metallic impurities, non-metallic impurities, and lattice defects.

8. The method of claim 1, wherein the wafer bulk of said wafers is hydrogenated with a sufficient hydrogenating intensity and for a time period to assure passivation of remaining electrically active defects in the wafer bulk.

9. The method of claim 1, further comprising the step of forming a solar cell using said semiconductor wafer.

10. The method of claim 1, wherein the method is performed on both surfaces of said semiconductor wafer.

## Patentansprüche

1. Verfahren zur Entfernung von Verunreinigungen aus minderqualitativen (low-grade) kristallinen Halbleiterwafern, das die Schritte umfasst:
Herstellen eines minderqualitativen Halbleiterwafers, der ein Substrat mit einem hohen Gehalt an Verunreinigungen aufweist;
mechanisches Schädigen mindestens einer Oberfläche des Halbleiterwafers, entweder in dem Herstellungsschritt oder in einem separaten Schritt, wobei auf der mindestens einen Oberfläche eine Gitterschädigung erzeugt wird, um eine Region auf der mindestens einen Oberfläche zu bilden, die eine Mehrzahl von Getter-Zentren aufweist;
Ausbreiten der Verunreinigungen von dem Substrat mit Hilfe eines Phosphor-Getter-Verfahrens, wobei das Phosphor-Getter-Verfahren den Schritt des Imprägnierens der mindestens einen Oberfläche mit einem Phosphormaterial und des Hinzufügens von einer oder mehrerer kontaminierter Schichten mit kontrollierten Niveaus anderer Getter-Agenzien auf der mindestens einen Oberfläche umfasst, wobei die anderen Getter-Agenzien aus Eisen, Nickel und Kupfer ausgewählt werden und eine Konzentration im Bereich von 10¹⁰-10¹⁷ cm⁻³ aufweisen, um Verunreinigungscluster zu erzeugen, die mit den Getter-Zentren assoziiert sind, wobei die Verunreinigungscluster die Verunreinigungen aufweisen, die ausgebreitet wurden; und
Entfernen eines Teils von der mindestens einen Oberfläche, welcher das imprägnierte Phosphormaterial, die Cluster von Verunreinigungen und die eine oder mehrere kontaminierten Schichten aufweist, von der mindestens einen Oberfläche, um einen Halbleiterwafer zu erhalten, der ein Substrat mit einem allgemein verringerten Gehalt an Verunreinigungen aufweist.

2. Verfahren gemäß Anspruch 1, wobei die mindestens eine Oberfläche beide Oberflächen eines Halbleiterwafers umfasst.

3. Verfahren gemäß Anspruch 1, wobei der Halbleiterwafer einen gereinigten (upgraded) metallurgischen Siliziumwafer umfasst.

4. Verfahren gemäß Anspruch 1, wobei der Schritt des Schädigens der mindestens einen Oberfläche des Halbleiterwafers ferner den Schritt des Schädigens der mindestens einen Oberfläche mit Hilfe einer Drahtsäge (wire saw) zum Schneiden des Halbleiterwafers von einem Halbleiteringot umfasst.

5. Verfahren gemäß Anspruch 1, wobei das Phosphor-Getter-Verfahren ferner das Erhitzen auf eine Temperatur von 900°C und für eine Dauer von einer Stunde umfasst, wodurch ein Flächenwiderstand des Halbleiterwafers von 10-40 Ω/Square erhalten wird.

6. Verfahren gemäß Anspruch 1, wobei der Schritt des Entfernens ferner den Schritt des Entfernen eines Teils von der mindestens einen Oberfläche umfasst, welcher das imprägnierte Phosphormaterial und die Verunreinigungscluster aufweist, mit Hilfe eines Schrittes des chemischem Ätzens des Teils, der das imprägnierte Phosphormaterial und die Verunreinigungscluster aufweist.

7. Verfahren gemäß Anspruch 1, wobei die Verunreinigungen Elemente aus der Gruppe aufweisen, welche im Wesentlichen aus Übergangsmetallen, metallischen Verunreinigungen, nicht-metallischen Verunreinigungen und gemischten oder reinen Clustern von Übergangsmetallen, metallischen Verunreinigungen, nicht-metallischen Verunreinigungen und Gitterschädigungen besteht.

8. Verfahren gemäß Anspruch 1, wobei die Halbleiterhauptmasse (wafer bulk) der Halbleiter mit ausreichender Intensität und über eine Zeitdauer zur Sicherstellung der Passivierung der verbliebenen elektrisch aktiven Defekte in der Halbleiterhauptmasse hydriert ist.

9. Verfahren gemäß Anspruch 1, das ferner den Schritt des Herstellens einer Solarzelle unter Verwendung des Halbleiterwafers umfasst.

10. Verfahren gemäß Anspruch 1, wobei das Verfahren auf beiden Oberflächen des Halbleiterwafers durchgeführt wird.

## Revendications

1. Procédé d'élimination d'impuretés à partir de bas grade plaquettes de semi-conducteur cristallin, comprenant les étapes consistant à:
former une plaquette de semi-conducteur à faible teneur comprenant un substrat ayant une teneur élevée en impuretés;
endommager mécanique au moins une surface de ladite plaquette de semi-conducteur, que ce soit dans ladite étape de formation ou dans une étape séparée, en formant ainsi des dégâts du réseau sur la au moins une surface, pour former une région de ladite au moins une surface comprenant une pluralité de centres dégazage (center getter);
diffusion d'impuretés à partir dudit substrat en utilisant un procédé dégazage en phosphore, ledit procédé dégazage (procédé getter) du phosphore comprenant l'étape d'imprégnation de ladite au moins une surface d'un matériau de phosphore et à ajouter une ou plusieurs couches contaminées avec des niveaux contrôlés d'autres agents de dégazage sur la au moins une surface, lesdits autres agents de dégazage (agents getters) étant choisis parmi le fer, le nickel et le cuivre et ayant une concentration allant de 10¹⁰-10¹⁷, pour former des amas d'impuretés associées à ladite centres dégazage, lesdits amas d'impuretés comprenant des impuretés qui diffuse; et
retirer de ladite au moins une surface d'une partie comprenant ledit matériau de phosphore imprégné, ledit amas d'impuretés et ledit une ou plusieurs couches contaminées à partir de ladite au moins une surface pour donner une plaquette de semi-conducteur comprenant un substrat ayant une teneur en impuretés généralement réduit.

2. Procédé selon la revendication 1, dans lequel ladite au moins une surface comprend deux surfaces d'une plaquette semi-conductrice.

3. Procédé selon la revendication 1, dans lequel ladite plaquette de semi-conducteur comprend une plaquette de silicium métallurgique améliorée.

4. Procédé selon la revendication 1, dans lequel ladite étape d'endommager ladite au moins une surface de ladite plaquette de semi-conducteur comprend en outre l'étape d'endommager ladite au moins une surface à l'aide d'une scie à fil à découper ladite plaquette semi-conductrice à partir d'un lingot de semi-conducteur.

5. Procédé selon la revendication 1, dans lequel ledit procédé dégazage du phosphore comprend en outre un chauffage à une température de 900°C et pendant une durée d'une heure, ce qui conduit à une résistance de la plaquette semi-conductrice de 10-40 Ω/carré.

6. Procédé selon la revendication 1, dans lequel ladite étape d'élimination comprend en outre l'étape consistant à retirer de ladite au moins une surface d'une partie comprenant ledit matériau de phosphore imprégné et ledit amas d'impuretés à l'aide d'une étape consistant à attaquer chimiquement ladite portion comprenant ledit amas d'impuretés imprégnées matériau de phosphore et ledit.

7. Procédé selon la revendication 1, dans lequel lesdites impuretés comprennent des éléments choisis dans le groupe consistant essentiellement en les métaux de transition, les impuretés non métalliques, les impuretés non-métalliques, et des groupes mixtes ou purs desdits métaux de transition, les impuretés non métalliques, les impuretés non-métalliques, et des défauts de réseau.

8. Procédé selon la revendication 1, dans lequel la majeure partie de la tranche desdites plaquettes est hydrogéné avec une intensité d'hydrogénation suffisante et pendant une période de temps afin d'assurer la passivation des défauts électriquement actifs restants dans la masse de la plaquette.

9. Procédé selon la revendication 1, comprenant en outre l'étape de formation d'une cellule solaire à l'aide de ladite plaquette de semi-conducteur.

10. Procédé selon la revendication 1, dans lequel le procédé est exécuté sur les deux surfaces de ladite plaquette semi-conductrice.
